(19) Europäisches Patentamt / European Patent Office / Office européen des brevets

(11) **EP 4 283 318 B1**

(12) **EUROPEAN PATENT SPECIFICATION**

(45) Date of publication and mention
of the grant of the patent:
**17.12.2025 Bulletin 2025/51**

(21) Application number: **23175435.9**

(22) Date of filing: **25.05.2023**

(51) International Patent Classification (IPC):
**G01R 31/367** (2019.01)      **G01R 31/374** (2019.01)
**G01R 31/3842** (2019.01)

(52) Cooperative Patent Classification (CPC):
**G01R 31/367; G01R 31/374; G01R 31/3842**

(54) **METHOD AND DEVICE FOR ESTIMATING STATE OF CHARGE OF A BATTERY**

VERFAHREN UND VORRICHTUNG ZUR SCHÄTZUNG DES LADEZUSTANDS EINER BATTERIE

PROCÉDÉ ET DISPOSITIF D'ESTIMATION DE L'ÉTAT DE CHARGE D'UNE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **25.05.2022 KR 20220064256**

(43) Date of publication of application:
**29.11.2023 Bulletin 2023/48**

(73) Proprietors:
• **Samsung SDI Co., Ltd.**
**Yongin-si, Gyeonggi-do 17084 (KR)**
• **POSTECH Research and Business Development Foundation**
**Pohang-si, Gyeongsangbuk-do (KR)**

(72) Inventors:
• **KIM, Jake**
**17084 Yongin-si (KR)**
• **KIM, Giheon**
**17084 Yongin-si (KR)**
• **KIM, Sangwoo**
**Pohang-si (KR)**
• **SONG, Youngbin**
**Pohang-si (KR)**
• **SEO, Minhwan**
**Pohang-si (KR)**

(74) Representative: **Marks & Clerk LLP**
**15 Fetter Lane**
**London EC4A 1BW (GB)**

(56) References cited:
**CN-A- 111 323 705     US-A1- 2015 377 974**

• **SHI NA ET AL: "State-of-charge estimation for the lithium-ion battery based on adaptive extended Kalman filter using improved parameter identification", JOURNAL OF ENERGY STORAGE, ELSEVIER BV, NL, vol. 45, 17 November 2021 (2021-11-17), XP086915383, ISSN: 2352-152X, [retrieved on 20211117], DOI: 10.1016/J.EST.2021.103518**
• **YANG LIN ET AL: "Supervisory long-term prediction of state of available power for lithium-ion batteries in electric vehicles", APPLIED ENERGY, ELSEVIER SCIENCE PUBLISHERS, GB, vol. 257, 21 October 2019 (2019-10-21), XP085898372, ISSN: 0306-2619, [retrieved on 20191021], DOI: 10.1016/ J.APENERGY.2019.114006**

Processed by Luminess, 75001 PARIS (FR)

**Description**

BACKGROUND

1. Field

One or more embodiments relate to a method of estimating a state of charge of a battery, and more particularly, to a method of estimating a state of charge of a battery by using a battery parametric model that is robust to changes in the ambient temperature.

2. Description of the Related Art

As a next-generation energy storage device, lithium ion batteries have many advantages such as high energy density, high power density, or long lifetime. The most important thing when using lithium-ion batteries is how efficiently and safely they are used. To this end, it is necessary to accurately estimate a state of charge (SOC) of the battery.

Initially, SOC estimation techniques applied to batteries at room temperature were developed, but as it is known that the ambient temperature has a great influence on the characteristics of a battery, SOC estimation techniques considering changes in ambient temperature have recently been studied. This is because applications with batteries may be exposed to not only to room temperature but also various ambient temperatures depending on the season and region in which they are operated.

One of the latest SOC estimation techniques is to convert parameter changes of a battery internal resistance (Rint) model into a look-up table through a preliminary temperature experiment in an ambient temperature range of 0 °C to 50 °C. This SOC estimation technique may compensate for a voltage modeling error generated from a simple internal resistance (Rint) model, with a constant term by using a temperature function generated through a preliminary temperature experiment, thereby improving the accuracy of voltage modeling and SOC estimation. However, there is an issue that preliminary battery characteristic tests at many temperature points are required to consider a wide range of ambient temperature.

Another SOC estimation technique estimates an SOC without compensating for a modeling error with a constant term in an ambient temperature range of -10 °C to 40 °C, by using a battery Thevenin model that is slightly more complicated than the internal resistance (Rint) model, but there is still an issue that it is impossible to accurately estimate an SOC unless a preliminary temperature experiment is performed to identify changes in parameter characteristics of the battery model at all temperature points within the ambient temperature range.

Still another SOC estimation technique estimates the internal resistance and capacitance of a battery in real time, which have been analyzed through a preliminary temperature experiment in the previous SOC estimation technique, reflect the internal resistance and capacitance in a battery model, and then estimate the SOC of the battery in an ambient temperature range of 10 °C to 40 °C, but there is a limitation in that an open-circuit voltage (OCV) characteristic curve of the battery, which is greatly affected by the ambient temperature, needs to be identified and applied through a preliminary temperature experiment.

Shi Na et al., Journal of Energy Storage, Elsevier, vol. 45, 2021-11-17, discloses a method for estimation of state of charge of a lithium-ion battery based on an adaptive extended Kalman filter using improved parameter identification. Firstly, a Thevenin equivalent circuit model is established and the recursive least squares with forgetting factor (FFRLS) method is used to achieve the parameter identification. Secondly, an evaluation factor is defined, and fuzzy control is used to realize the mapping between the evaluation factor and the correction value of the forgetting factor, so as to realize the adaptive adjustment of the forgetting factor. Finally, the noise adaptive algorithm is introduced into the extended Kalman filtering algorithm (AEKF) to estimate the state of charge (SOC) based on the identification results, which is applied to the parameter identification at the next time and executed circularly, so as to realize the accurate estimation of SOC.

US 2015/0377974 A1 discloses a battery state estimation method.

SUMMARY

According to the invention, a battery parametric model for accurately estimating the state of charge (SOC) of a battery even when a battery operating temperature environment changes according to the season and region is used. In the related art, the accuracy of battery SOC estimation was improved after identifying changes in battery characteristics in a wide temperature range through a preliminary temperature experiment, but according to the disclosure, it is sufficient to perform a battery characteristic test at one representative temperature (e.g., room temperature). According to one or more embodiments, robustness to temperature changes may be obtained by compensating for and reflecting changes in battery characteristics with respect to temperature, in parameters of a battery parametric model. One or more embodiments include a method and device for estimating an SOC and capable of reducing errors in voltage modeling and SOC estimation.

The invention, as defined by claims 1 and 10, includes a method and device for accurately estimating an SOC of a battery by using recursive least squares (RLS) and an extended Kalman filter (EKF).

Additional aspects will be set forth in part in the description which follows and, in part, will be apparent from the description, or may be learned by practice of the presented embodiments of the disclosure.

According to the invention, a method of estimating a state of charge of a battery according to claim 1 is provided.

The first to third parameter values $\alpha_1(k)$, $\alpha_2(k)$, and $\alpha_3(k)$ may be estimated to minimize the square of an error e(k) between the present voltage value $V_t(k)$ and the present voltage estimation value $V^\wedge_t(k)$.

A parameter matrix $\theta(k)$ consisting of the first to third parameter values $\alpha_1(k)$, $\alpha_2(k)$, and $\alpha_3(k)$ may be determined by the following equation:

$$\theta(k)=\theta(k-1)+K(k)e(k).$$

Here, K(k) may be a gain matrix, and the error e(k) may be determined according to $e(k)=V_t(k)-V^\wedge_t(k)$.

The present voltage estimation value $V^\wedge_t(k)$ may be determined by using a regressor matrix $\Phi(k)$ consisting of the reference open-circuit voltage value $Voc,_{ref}(k)$, the present current value $I_L(k)$, and the previous current value $I_L(k-1)$, and a previous value $\theta(k-1)$ of the parameter matrix, according to $V^\wedge_t(k)=\theta^T(k-1)\Phi(k)$.

Here, the regressor matrix $\Phi(k)$ is defined according to $\Phi(k)=[Voc,_{ref}(k), I_L(k), I_L(k-1)]^T$, and the parameter matrix $\theta(k)$ is defined according to $\theta(k)=[\alpha_1(k), \alpha_2(k), \alpha_3(k)]^T$.

The gain matrix K(k) may be determined by the following equation:

$$K(k)=P(k)\Phi(k)=P(k-1)\Phi(k)/[\lambda(k)+\Phi^T(k)P(k-1)\Phi(k)].$$

Here, P(k) is a covariance matrix and $\lambda(k)$ is a forgetting factor.

The covariance matrix P(k) may be determined by the following equation:

$$P(k)=(P(k-1)-K(k)\Phi^T(k)P(k-1))/\lambda(k).$$

The value of the forgetting factor $\lambda(k)$ may decrease when the difference between the present voltage value $V_t(k)$ and the previous voltage value $V_t(k-1)$ is greater than a preset value.

The EKF may include a state equation defined according to $SOC(k+1)=SOC(k)+ (\eta T/C_n)*I_L(k)+w(k)$, and a battery model equation defined according to $Vt(k)=\alpha_1(k)h(SOC(k))+\alpha_2(k)I_L(k)+\alpha_3(k)I_L(k-1)+v(k)$.

Here $\eta$ may be a charge and discharge efficiency, T may be a sampling period, $C_n$ may be the capacity of the battery, w(k) may be process noise, v(k) may be observation noise, h(SOC(k)) may be the reference open-circuit voltage value $V_{OC,ref}(k)$.

According to the invention, a computer program according to claim 9 is provided.

According to the invention, a device for estimating a state of charge of a battery according to claim 10 is provided.

At least some of the above features that accord with the invention and other features according to the invention are set out in the claims.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic configuration diagram of a battery system for performing a method of estimating a state of charge of a battery, according to an embodiment;

FIG. 2 is a flowchart for executing a method of estimating a state of charge of a battery according to an embodiment;

FIG. 3 is an internal configuration diagram of a microprocessor according to an embodiment;

FIG. 4 exemplarily illustrates a curve representing an SOC-$V_{OC,ref}$ relationship obtained by a preliminary experiment at a representative reference temperature of 20 °C;

FIG. 5 illustrates a Thevenin equivalent circuit model of a battery;

FIG. 6 shows a current waveform input to a battery to verify the accuracy of a method of estimating a state of charge of a battery according to the disclosure;

FIG. 7 shows relative errors between battery voltages estimated according to the related art and actually measured voltages (Method A and Method B), and relative errors between battery voltages estimated according to the disclosure and actually measured voltages (Proposed method);

FIG. 8 shows relative errors between states of charge of a battery estimated by using the related art (Method A and Method B) and the method according to the disclosure (Proposed method), by measuring the battery voltage while continuously discharging the battery at -8 °C with the current waveform shown in FIG. 6, and actual states of charge; FIG. 9 shows a real-time variable ambient temperature situation that is expected to occur in battery operation in winter; and

FIG. 10 shows the voltage (Measurement) measured when a battery is discharged in the variable temperature situation shown in FIG. 9, and the battery voltage (Estimation) estimated by using a method according to the disclosure.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items.

Advantages and features of the disclosure and a method for achieving them will be apparent with reference to embodiments described below together with the attached drawings. The disclosure may, however, be embodied in many different forms and should not be construed as being limited to the embodiments set forth herein, rather the invention is defined by the claims. In describing the disclosure, detailed explanations of the related art are omitted when it is deemed that they may unnecessarily obscure the gist of the disclosure.

Terms used herein are for describing particular embodiments and are not intended to limit the scope of the disclosure. A singular expression may include a plural expression unless they are definitely different in a context. As used herein, terms such as "comprises," "includes," or "has" specify the presence of stated features, numbers, stages, operations, components, parts, or a combination thereof, but do not preclude the presence or addition of one or more other features, numbers, stages, operations, components, parts, or a combination thereof. Terms such as "first" or "second" may be used to describe various elements, but the elements should not be limited by the terms. These terms are only used to distinguish one element from another element.

Hereinafter, embodiments will be described in detail with reference to the accompanying drawings, and the same or corresponding components are denoted by the same reference numerals when described with reference to the accompanying drawings, and thus, redundant descriptions thereof will be omitted.

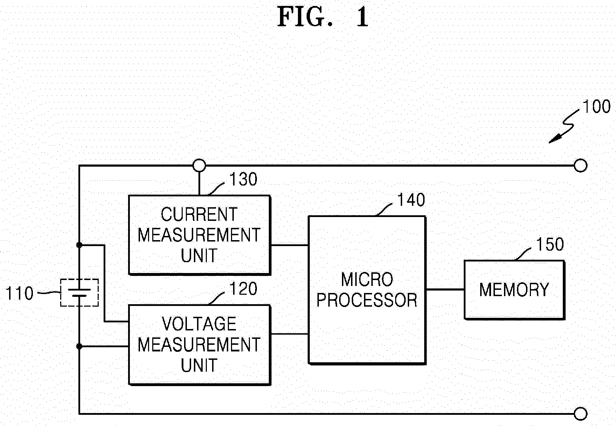

FIG. 1 is a schematic configuration diagram of a battery system for performing a method of estimating a state of charge (SOC) of a battery, according to an embodiment.

Referring to FIG. 1, a battery system 100 may include a battery 110, a voltage measurement unit 120, a current measurement unit 130, a microprocessor 140, and a memory 150.

The battery 110 is a component that stores power and includes at least one battery cell. The battery 110 may include a plurality of battery cells. The battery cells may be connected to each other in series, in parallel, or in a combination of series and parallel connections.

The battery cell may include a rechargeable secondary battery. For example, the battery cells may include a nickel-cadmium battery, a lead-acid battery, a nickel-metal hydride (NiMH) battery, a lithium-ion battery, a lithium polymer battery, etc. The number of battery cells included in the battery 110 may be determined according to a required output voltage.

Although FIG. 1 illustrates one battery 110, a plurality of batteries 110 may be connected to each other in parallel and/or in series, and may be connected to a load and/or a charging device through external terminals. The battery 110 may be electrically connected to an electric load and/or a charging device and operating, and may be discharging to supply power to the electric load or being charged by receiving power from the charging device. For example, the battery 110 may be mounted on an electric vehicle, electric power stored in the battery 110 may be supplied to a motor of the electric vehicle to drive the electric vehicle, and electric power generated during regenerative braking of the electric vehicle may be supplied to the battery 110. In the specification, that the battery 110 is operating means discharging current to the motor to drive the electric vehicle or charging the battery 110 with current generated by regenerative braking, as described above.

The voltage measurement unit 120 may be connected to both terminals of the operating battery 110 to periodically measure the voltage of the battery 110 to generate a voltage value. For example, the voltage measurement unit 120 may measure the voltage of both terminals of the battery 110 at a sampling time period $\Delta t$, and a recently measured voltage value may be referred to as a present voltage value and may be expressed as $V_t(k)$. In addition, a voltage value measured before the sampling time period $\Delta t$ may be referred to as a previous voltage value and may be expressed as $V_t(k-1)$. The sampling time period $\Delta t$ may be, for example, 1 second. However, this is an example, and the sampling time

period $\Delta t$ may be set to other time periods. For example, the sampling time period $\Delta t$ may be set to 0.1 seconds, 0.5 seconds, 2 seconds, 5 seconds, or 10 seconds. The sampling time period $\Delta t$ may be appropriately set according to an electrical system in which the battery 110 is used.

k and k-1 denote the sampling times of the measured values, $V_t(k)$ denotes the currently measured value, $V_t(k-1)$ denotes the previously measured value, and $V_t(k+1)$ denotes the next measured value.

Although FIG. 1 illustrates that the voltage measurement unit 120 measures the voltage of both terminals of the battery 110, but the voltage measurement unit 120 may also be connected between external terminals of the battery system 100 to periodically measure the terminal voltage of the battery 110. According to another embodiment, in a case in which the battery 110 is composed of a plurality of battery cells, a plurality of battery modules, or a plurality of battery packs, the voltage measurement unit 120 may measure the voltage of both terminals of each battery cell, each battery module, or each battery pack.

The current measurement unit 130 may periodically measure the current of the operating battery 110 to generate a current value. The voltage measurement unit 120 and the current measurement unit 130 may be synchronized with each other to measure the voltage and current of the battery 110 at the same time point. The current measurement unit 130 may measure the current of the battery 110 at the sampling time period $\Delta t$. The current value measured by the current measurement unit 130 may be expressed as positive (+) when the current is a charging current, and as negative (-) when the current is a discharging current. A recently measured current value may be referred to as a present current value and expressed as $I_L(k)$, and a current value measured before the sampling time period $\Delta t$ may be referred to as a previous current value and expressed as $I_L(k-1)$.

For example, the current measurement unit 130 may measure a current according to a current waveform for electric vehicle verification, which is periodically input to the battery 110, and at the same time, the voltage measurement unit 120 may measure a terminal voltage output from the battery 110.

The microprocessor 140 may estimate an SOC of the battery 110 based on a voltage value provided by the voltage measurement unit 120 and a current value provided by the current measurement unit 130. The microprocessor 140 may determine a reference open-circuit voltage value $V_{OC,ref}(k)$, estimate first to third parameter values $\alpha_1(k)$, $\alpha_2(k)$, and $\alpha_3(k)$ based on a present voltage value $V_t(k)$, the reference open-circuit voltage value $V_{OC,ref}(k)$, a present current value $I_L(k)$, and a previous current value $I_L(k-1)$, and generate a next SOC estimation value SOC(k+1) of the battery 110 by using the first to third parameter values $\alpha_1(k)$, $\alpha_2(k)$, and $\alpha_3(k)$. After the sampling time period $\Delta t$, the next SOC estimation value SOC(k+1) becomes a present SOC estimation value SOC(k), and the microprocessor 140 is configured to determine the reference open-circuit voltage value $V_{OC,ref}(k)$ based on the present SOC estimation value SOC(k).

Although it is described herein that the next SOC estimation value SOC(k+1) of the battery 110 is generated by using the first to third parameter values $\alpha_1(k)$, $\alpha_2(k)$, and $\alpha_3(k)$, it may also be understood that, when the present SOC estimation value SOC(k) is generated and the present SOC estimation value SOC(k) becomes a previous SOC estimation value SOC(k-1) after the sampling time period $\Delta t$, the reference open-circuit voltage value $V_{OC,ref}(k)$ is determined based on the previous SOC estimation value SOC(k-1).

The microprocessor 140 may determine the reference open-circuit voltage value $V_{OC,ref}(k)$ corresponding to the present SOC estimation value SOC(k), by using an SOC-$V_{OC,ref}$ relationship between an SOC value and an open-circuit voltage value of the battery 110 obtained by a preliminary experiment at a reference temperature. The reference temperature may be, for example, 20 °C. The SOC-$V_{OC,ref}$ relationship may be stored in the memory 150 in the form of a lookup table. The present SOC estimation value SOC(k) is the next SOC estimation value SOC(k+1) generated by the microprocessor 140 before the sampling time period $\Delta t$. The present SOC estimation value SOC(k) may be referred to as an SOC estimation value SOC(k).

The microprocessor 140 may use an adaptive filter to estimate the first to third parameter values $\alpha_1(k)$, $\alpha_2(k)$, and $\alpha_3(k)$ based on the present voltage value $V_t(k)$, the reference open-circuit voltage value $V_{OC,ref}(k)$, the present current value $I_L(k)$, and the previous current value $I_L(k-1)$. The adaptive filter used by the microprocessor 140 may be a filter using recursive least squares (RLS) or a filter using weighted least squares (WLS). An embodiment in which the microprocessor 140 uses RLS will be described in detail below.

The microprocessor 140 may generate the next SOC estimation value SOC(k+1) of the battery 110 by using the first to third parameter values $\alpha_1(k)$, $\alpha_2(k)$, and $\alpha_3(k)$ generated in real time. The microprocessor 140 may use an extended Kalman filter (EKF) to generate the next SOC estimation value SOC(k+1).

Because the microprocessor 140 may perform, with the four fundamental arithmetic operations, a method of estimating an SOC of a battery according to the present embodiment, the microprocessor 140 may be included in a battery management system (BMS) of a battery pack. According to another embodiment, the microprocessor 140 may be included in a BMS or an engine control unit (ECU) of an electric vehicle. According to another embodiment, microprocessor 140 may be included in a controller of an energy storage system. According to another embodiment, the microprocessor 140 may be implemented as a processor of a server communicatively connected to a battery system or an energy storage system.

The memory 150 may store instructions and data necessary for the microprocessor 140 to perform the method of

# EP 4 283 318 B1

estimating an SOC of a battery according to the present embodiment. The memory 150 may store an SOC-$V_{OC,ref}$ relationship between an SOC value and an open-circuit voltage value of the battery 110 obtained by a preliminary experiment at a reference temperature, in the form of a lookup table.

According to the present embodiment, only the present voltage value $V_t(k)$, the present current value $I_L(k)$, the reference open-circuit voltage value $Voc,_{ref}(k)$, the previous current value $I_L(k-1)$, the SOC estimation value SOC(k), the first to third parameter values $\alpha_1(k)$, $\alpha_2(k)$, and $\alpha_3(k)$, etc. are stored in the memory 150, and long-term voltage data or current data does not need to be stored in the memory 150. Because there is no need for the memory 150 to store a large amount of instructions and data, the memory 150 may be implemented as a small-sized memory. For example, the memory 150 may be implemented as a memory within the microprocessor 140.

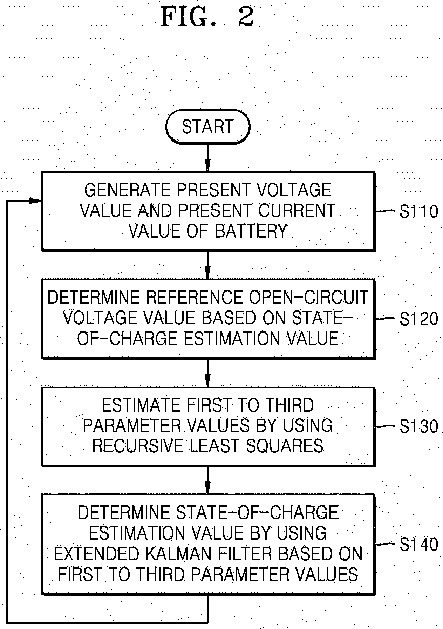

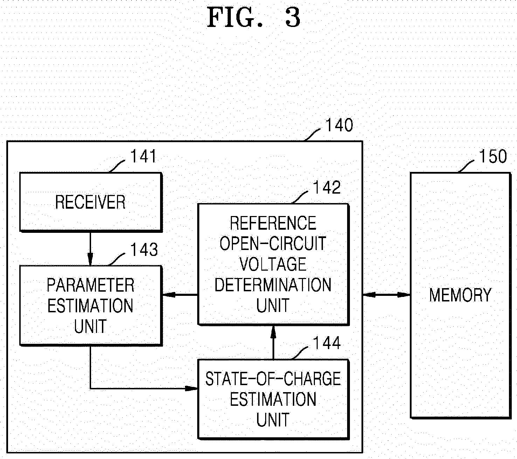

FIG. 2 is a flowchart for executing a method of estimating an SOC of a battery according to an embodiment, and FIG. 3 is an internal configuration diagram of a microprocessor according to an embodiment.

Referring to FIGS. 1 to 3, the microprocessor 140 includes a receiver 141, a reference open-circuit voltage determination unit 142, a parameter estimation unit 143, and an SOC estimation unit 144. The microprocessor 140 may be connected to the memory 150, and may refer to an SOC-$V_{OC,ref}$ relationship between an SOC value and an open-circuit voltage value of the battery 110 stored in the memory 150 in the form of a lookup table. The microprocessor 140 may temporarily store, in the memory 150, data necessary for executing the method of estimating an SOC of a battery.

The microprocessor 140 and the memory 150 may configure a device for estimating an SOC of a battery. The device for estimating an SOC of a battery may be a battery pack or a battery system including a plurality of battery packs. The device for estimating an SOC of a battery may be an electric vehicle, an electric device, or an energy storage system equipped with a battery pack or a battery system.

The method of estimating an SOC of a battery according to the disclosure uses a battery parametric model, which uses only an SOC-$V_{OC,ref}$ relationship obtained based on a representative room temperature without a preliminary temperature experiment to analyze changes in battery characteristics at various ambient temperatures, and thus is robust to changes in ambient temperature. The battery parametric model includes the first to third parameter values $\alpha_1(k)$, $\alpha_2(k)$, and $\alpha_3(k)$ as model parameters.

The method of estimating an SOC of a battery according to the disclosure may estimate model parameters such as the first to third parameter values $\alpha_1(k)$, $\alpha_2(k)$, and $\alpha_3(k)$ in real time in various temperature environments based on the battery parametric model, and estimate an SOC of the battery 110 based on the model parameters.

In the method of estimating an SOC of a battery according to an embodiment, the present voltage value $V_t(k)$ and the present current value $I_L(k)$ may be generated by detecting the voltage and current of the battery 110 (S110).

The receiver 141 may receive, from the voltage measurement unit 120, the present voltage value $V_t(k)$ generated by detecting the voltage of the battery 110, and receive, from the current measurement unit 130, the present current value $I_L(k)$ generated by detecting the current of the battery 110. The receiver 141 may directly receive the voltage of the battery 110 and generate the present voltage value $V_t(k)$.

The reference open-circuit voltage value $V_{OC,ref}(k)$ may be determined based on the SOC estimation value SOC(k) (S120).

The memory 150 may store an SOC-$V_{OC,ref}$ relationship between an SOC value and an open-circuit voltage value of the battery 110 obtained by a preliminary experiment at a reference temperature, in the form of a lookup table. The memory 150 does not need to store a plurality of SOC-Voc relationships obtained at various ambient temperatures. Only one SOC-$V_{OC,ref}$ relationship obtained by a preliminary experiment at a reference temperature may be stored in the memory 150.

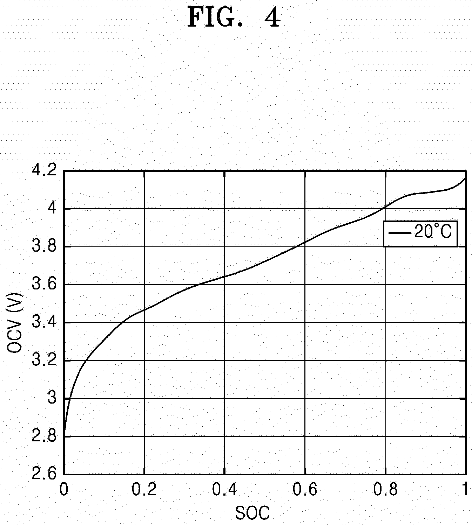

The relationship between an SOC and an open-circuit voltage $V_{oc}$ of the battery 110 and the SOC-Voc relationship vary greatly depending on various ambient temperatures. In a method in the related art, SOC-Voc relationships are obtained at all ambient temperatures and used for an SOC algorithm, but in the disclosure, only the SOC-$V_{OC,ref}$ relationship obtained at one representative reference temperature is used to estimate the voltage and SOC of a battery. FIG. 4 exemplarily shows a curve representing an SOC-$V_{OC,ref}$ relationship obtained by a preliminary experiment at a representative reference temperature of 20 °C.

The reference open-circuit voltage determination unit 142 may determine the reference open-circuit voltage value $V_{OC,ref}(k)$ corresponding to the SOC estimation value SOC(k) by using the SOC-$V_{OC,ref}$ relationship stored in the memory 150.

The reference open-circuit voltage determination unit 142 may continuously provide the reference open-circuit voltage value $V_{OC,ref}(k)$ for the parameter estimation unit 143 to estimate the first to third parameter values $\alpha_1(k)$, $\alpha_2(k)$, and $\alpha_3(k)$ of the battery parametric model. The reference open-circuit voltage value $V_{OC,ref}(k)$ may be determined to correspond to the SOC estimation value SOC(k), based on the SOC-$V_{OC,ref}$ relationship obtained through a preliminary experiment at a representative reference temperature, for example, a room temperature of 20 °C.

The SOC estimation value SOC(k) is equal to the next SOC estimation value SOC(k+1) generated by the SOC estimation unit 144 before the sampling time period $\Delta t$.

Because there is no next SOC estimation value SOC(k+1) in the initial stage of executing the method of estimating an SOC of a battery of the disclosure, the reference open-circuit voltage determination unit 142 may determine the present voltage value $V_t(k)$ as being equal to the reference open-circuit voltage value $V_{OC,ref}(k)$. Thereafter, when the SOC estimation unit 144 determines the next SOC estimation value SOC(k+1) of the battery 110 after a preset time period, for example, after the sampling time period $\Delta t$, then after the sampling time period $\Delta t$ again, the next SOC estimation value SOC(k+1) becomes the SOC estimation value SOC(k), and the reference open-circuit voltage value $V_{OC,ref}(k)$ corresponding to the SOC estimation value SOC(k) may be determined by using the SOC-$V_{OC,ref}$ relationship and provided to the parameter estimation unit 143. The reference open-circuit voltage value $V_{OC,ref}(k)$ is used to determine the next SOC estimation value SOC(k+1). This process may be repeated while the method of estimating an SOC of a battery is executed.

The first to third parameter values $\alpha_1(k)$, $\alpha_2(k)$, and $\alpha_3(k)$ may be estimated by using RLS, based on the present voltage value $V_t(k)$, the reference open-circuit voltage value $V_{OC,ref}(k)$, the present current value $I_L(k)$, and the previous current value $I_L(k-1)$ (S130).

The parameter estimation unit 143 may be provided with a current $I_L$ input to the battery 110 and a battery terminal voltage $V_t$ measured in the battery 110, and may use RLS to estimate first to third parameters $\alpha_1$, $\alpha_2$, and $\alpha_3$ of the battery parametric model in real time. For example, the parameter estimation unit 143 may receive the present voltage value $V_t(k)$, the present current value $I_L(k)$, and the previous current value $I_L(k-1)$ from the receiver 141, receive the reference open-circuit voltage value $V_{OC,ref}(k)$ from the reference open-circuit voltage determination unit 142, and estimate the first to third parameter values $\alpha_1(k)$, $\alpha_2(k)$, and $\alpha_3(k)$ by using RLS based on the present voltage value $V_t(k)$, the reference open-circuit voltage value $V_{OC,ref}(k)$, the present current value $I_L(k)$, and the previous current value $I_L(k-1)$.

The parameter estimation unit 143 uses a battery parametric model according to the disclosure. Unlike an electrical internal resistance (Rint) model or a Thevenin model used in the related art, the battery parametric model is designed to be robust against ambient temperature while using limited battery information.

As shown in Equation 1 below, the battery parametric model consists of a reference open-circuit voltage term $V_{OC,ref}(k)$ and two terms $I_L(k)$ and $I_L(k-1)$ related to an input current.

[Equation 1]

$$V_t(k)=\alpha_1(k)V_{OC,ref}(k)+\alpha_2(k)I_L(k)+\alpha_3(k)I_L(k-1)$$

$\alpha_1(k)$, which is the coefficient of the open-circuit voltage term, compensates for the variation of an open-circuit voltage $V_{oc}$ of the battery 110, which changes due to the ambient temperature and aging of the battery, based on a reference open-circuit voltage $V_{oc,ref}$, and thus enables battery modeling that is robust to various ambient temperature changes. $\alpha_2(k)$ and $\alpha_3(k)$, which are the coefficients of the current terms, may be described as parameters respectively denoting battery internal resistance denoting a battery voltage drop by the currently input current $I_L(k)$, and a polarization voltage at which the battery voltage fluctuates due to the difference between the previously input current $I_L(k-1)$ and the currently input current $I_L(k)$.

The parameter estimation unit 143 may apply RLS by using the current and voltage of the battery 110 measured in real time and the reference open-circuit voltage $V_{oc,ref}$ provided by a reference open-circuit voltage selection unit 200. As such, the parameter estimation unit 143 may estimate the first to third parameter values $\alpha_1(k)$, $\alpha_2(k)$, and $\alpha_3(k)$ of the battery parametric model.

The battery parametric model according to the disclosure is applied with two assumptions to apply RLS to a battery Thevenin model in the related art. In addition, the disclosure complements an RLS algorithm in order to accurately estimate the parameters of the battery parametric model. By using the battery parametric model, it is possible to improve the accuracy of estimation of the battery voltage and estimation of an SOC robustly to temperature changes even without conducting a plurality of preliminary temperature experiments to identify changes in battery characteristics according to various ambient temperatures.

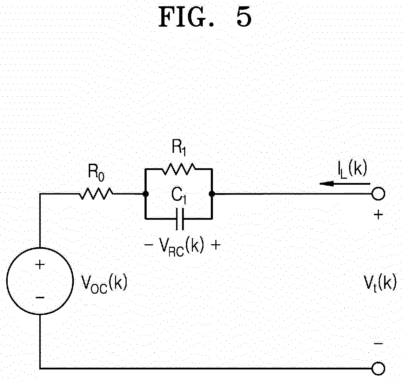

The parameter estimation unit 143 uses a battery parametric model that is robust to temperature changes. Equation 1 of the battery parametric model is derived from a battery Thevenin model equation as Equation 2 below. FIG. 5 illustrates a Thevenin equivalent circuit model of a battery. Equation 2 is a battery Thevenin model equation in the related art.

[Equation 2]

$$V_t(k)=V_{OC}(k)+R_0 I_L(k)+V_{RC}(k)$$

$$V'_{RC}(k)=I_L(k)/C_1-V_{RC}(k)/C_1 R_1$$

Here, Voc(k) denotes an open-circuit voltage value of the battery 110, $I_L(k)$ denotes a present current value, $V_t(k)$

denotes a present voltage value, $V_{RC}(k)$ denotes a present resistor-capacitor (RC) voltage value, and they are represented in the battery Thevenin model of FIG. 5. $R_0$ denotes a series internal resistor, and $R_1$ and $C_1$ denote a parallel internal resistor and a capacitor, respectively.

Equation 3 is an equation obtained by Laplace transform of Equation 2.

[Equation 3]

$$V_t(s)=V_{OC}(s)+R_0I_L(s)+V_{RC}(s)$$

$$=V_{OC}(s)+R_0I_L(s)+R_1I_L(s)/(1+R_1C_1s)$$

By substituting $T^{-1}(1-Z^{-1})$ for s in Equation 3 and rearranging it in order to apply a backward difference method to Equation 3, Equation 4 below is obtained.

[Equation 4]

$$\{V_t(s)-V_{OC}(s)\}/I_L(s)=R_0+TR_1/(T+R_1C_1(1-Z^{-1}))$$

$$=[(TR_0+TR_1+R_0R_1C_1)/(T+R_1C_1)-R_0R_1C_1Z^{-1}/(T+R_1C_1)]/[1+R_1C_1Z^{-1}/(T+R_1C_1)]$$

Equation 4 is transformed to Equation 5 below.

Equation 5]

$$\{V_t(k)-V_{OC}(k)\}/I_L(k)=(a_2+a_3Z^{-1})/(1-a_1Z^{-1})$$

$$(1-a_1Z^{-1})\{V_t(k)-V_{OC}(k)\}=(a_2+a_3Z^{-1})I_L(k)$$

Here, $a_1$ is $-R_1C_1/(T+R_1C_1)$, $a_2$ is $(TR_0+TR_1+R_0R_1C_1)/(T+R_1C_1)$, and $a_3$ is $-R_0R_1C_1/(T+R_1C_1)$.

Again, Equation 5 is transformed to Equation 6 below.

[Equation 6]

$$V_t(k)-V_{OC}(k)-a_1\{V_t(k-1)-V_{OC}(k-1)\}=a_2I_L(k)+a_3I_L(k-1)$$

$$V_t(k)-a_1V_t(k-1)=V_{OC}(k)-a_1V_{OC}(k-1)+a_2I_L(k)+a_3I_L(k-1)$$

In the related art, Equation 3 is transformed to Equation 6 to estimate the open-circuit voltage Voc and the parameters $a_1$, $a_2$, and $a_3$, and the estimated parameters $a_1$, $a_2$, and $a_3$ are transformed to Thevenin model parameters $R_0$, $R_1$, and $C_1$ of Equation 3. Because the open-circuit voltage Voc and the Thevenin model parameters $R_0$, $R_1$, and $C_1$ estimated in the related art vary greatly under the influence of the ambient temperature, it has the disadvantage that it is necessary to obtain a lookup table showing the change trend of each of the open circuit voltage Voc and the Thevenin model parameters $R_0$, $R_1$, and $C_1$ according to temperature change through preliminary experiments at numerous temperature points within a desired ambient temperature range. In addition, the battery Thevenin model has a fundamental disadvantage that a voltage estimation error occurs as the temperature increases or decreases with respect to room temperature. In addition, for a temperature for which no preliminary experiments have been performed, approximate model parameters need to be obtained by interpolation or extrapolation using the lookup table, and in this process, model parameter errors and voltage estimation errors occur.

According to the disclosure, an equation such as Equation 8 is derived by applying two assumptions as Equation 7 below to Equation 6.

[Equation 7]

$$V_{OC}(k) \fallingdotseq V_{OC}(k-1)$$

$$V_t(k) \fallingdotseq V_t(k-1)$$

[Equation 8]

$$V_t(k) = V_{OC}(k) + \{a_2/(1-a_1)\}I_L(k) + \{a_3/(1-a_1)\}I_L(k-1)$$

The first assumption of Equation 7 is commonly used in the related art. The second assumption of Equation 7 is established when the instantaneous change in the current IL input to the battery 110 is not large. When the second assumption is not satisfied, that is, when the difference in one step of the measured voltage is greater than or equal to a particular value, by lowering the size of a forgetting factor $\lambda$ of the RLS, it is possible to reflect a modeling error that occurs when the second assumption is not satisfied, and estimate accurate model parameters. For example, when the difference between the present voltage value $V_t(k)$ and the previous voltage value $V_t(k-1)$ is greater than a certain value, the value of the forgetting factor $\lambda(k)$ may be reduced.

By changing the first term Voc(k) corresponding to the open-circuit voltage in Equation 8 to a term including the reference open-circuit voltage value $V_{OC,ref}(k)$, and simplifying the coefficients expressed as the parameters $a_1$, $a_2$, and $a_3$, a model equation of the battery parametric model of the disclosure is derived as in Equation 9 below.

[Equation 9]

$$V_t(k) = \alpha_1(k)V_{OC,ref}(k) + \alpha_2(k)I_L(k) + \alpha_3(k)I_L(k-1)$$

Here, $\alpha_2(k)$ is $a_2/(1-a_1)$, and $\alpha_3(k)$ is $a_3/(1-a_1)$. $\alpha_1(k)$ denotes a value for compensating for factors such as ambient temperature and aging that affect the open-circuit voltage of the battery.

By substituting the reference open-circuit voltage value $V_{OC,ref}(k)$ for the first term in Equation 9 of the battery parametric model, SOC-Voc curves obtained at numerous temperature points required in the related art are not required. That is, when factors such as ambient temperature and aging that affect the open-circuit voltage of the battery 110, exist, the variation occurring in the open-circuit voltage is compensated for through $\alpha_1(k)$ with respect to the reference open-circuit voltage. Accordingly, SOC-Voc curves obtained at different ambient temperatures are no longer required.

The first to third parameter values $\alpha_1(k)$, $\alpha_2(k)$, and $\alpha_3(k)$ of the battery parametric model are estimated in real time by the parameter estimation unit 143 through RLS. By using, as a voltage model equation, Equation 9 that uses the first to third parameter values $\alpha_1(k)$, $\alpha_2(k)$, and $\alpha_3(k)$ without the need to transform them to Thevenin model parameters as in the related art, voltage estimation errors may be greatly reduced.

The battery parametric model is expressed as Equation 10 below with a regressor matrix $\Phi(k)$ and a parameter matrix $\theta(k)$.

[Equation 10]

$$V_t(k) = \theta^T \Phi = \theta^T(k)\Phi(k)$$

Here, $V_t(k)$ denotes a present voltage value.

The regressor matrix $\Phi(k)$ consists of the reference open-circuit voltage value $V_{OC,ref}(k)$, the present current value $I_L(k)$, and the previous current value $I_L(k-1)$, and is defined as in Equation 11 below.

[Equation 11]

$$\Phi(k) = [V_{OC,ref}(k), \ I_L(k), \ I_L(k-1)]^T$$

When the parameter matrix $\theta(k)$ consists of the first to third parameter values $\alpha_1(k)$, $\alpha_2(k)$, and $\alpha_3(k)$, the parameter matrix $\theta(k)$ is defined as in Equation 12 below.

[Equation 12]

$$\theta(k) = [\alpha_1(k),\ \alpha_2(k),\ \alpha_3(k)]^T$$

The parameter estimation unit 143 may estimate the parameter matrix $\theta(k)$ to minimize the square of an error $e(k)$ between the present voltage value $V_t(k)$ and the present voltage estimation value $V\hat{}_t(k)$, according to RLS. For example, the parameter matrix $\theta(k)$ may be determined by Equation 13 below.

[Equation 13]

$$\theta(k) = \theta(k-1) + K(k)e(k)$$

Here, $K(k)$ denotes a gain matrix, the error $e(k)$ is defined as $e(k) = V_t(k) - V\hat{}_t(k)$, and the present voltage estimation value $V\hat{}_t(k)$ is determined as in Equation 14 below by using the regressor matrix $\Phi(k)$ and the previous value $\theta(k-1)$ of the parameter matrix.

[Equation 14]

$$V\hat{}_t(k) = \theta^T(k-1)\Phi(k)$$

The gain matrix $K(k)$ is determined by Equation 15 below.

[Equation 15]

$$K(k) = P(k)\Phi(k) = P(k-1)\Phi(k)/[\lambda(k) + \Phi^T(k)P(k-1)\Phi(k)]$$

Here, $P(k)$ denotes a covariance matrix and $\lambda(k)$ denotes a forgetting factor. The value of the forgetting factor $\lambda(k)$ is an integer value between 0 and 1, and as the value of the forgetting factor $\lambda(k)$ approaches 1, the present voltage value $V_t(k)$ and the present current value $I_L(k)$ affects the first to third parameter values $\alpha_1(k)$, $\alpha_2(k)$, and $\alpha_3(k)$ for a long time, and as the value of the forgetting factor $\lambda(k)$ approaches 0, the present voltage value $V_t(k)$ and the present current value $I_L(k)$ affects the first to third parameter values $\alpha_1(k)$, $\alpha_2(k)$, and $\alpha_3(k)$ only for a short time. The value of the forgetting factor $\lambda(k)$ may be set to decrease when the difference between the present voltage value $V_t(k)$ and the previous voltage value $V_t(k-1)$ is greater than a preset value.
The covariance matrix $P(k)$ is determined by Equation 16 below.

[Equation 16]

$$P(k) = (P(k-1) - K(k)\Phi^T(k)P(k-1))/\lambda(k)$$

The parameter estimation unit 143 may estimate the first to third parameter values $\alpha_1(k)$, $\alpha_2(k)$, and $\alpha_3(k)$ of the battery parametric model in real time by calculating the present voltage estimation value $V\hat{}_t(k)$ through the previous value $\theta(k-1)$ of the estimated parameter matrix and the measured regressor matrix $\Phi(k)$, calculating the error $e(k)$ between the present voltage value $V_t(k)$ and the present voltage estimation value $V\hat{}_t(k)$, and then varying the degree of updating the present value $\theta(k)$ of the parameter matrix according to the degree of the error $e(k)$.
The next SOC estimation value SOC(k+1) of the battery 110 may be determined by using an EKF, based on the SOC estimation value SOC(k), the present voltage value $V_t(k)$, the reference open-circuit voltage value $V_{OC,ref}(k)$, the present current value $I_L(k)$, the previous current value $I_L(k-1)$, and the first to third parameter values $\alpha_1(k)$, $\alpha_2(k)$, and $\alpha_3(k)$ (S140).
The SOC estimation unit 144 may estimate a battery voltage $V'_t$ in real time by using the first to third parameters $\alpha_1$, $\alpha_2$, and $\alpha_3$ estimated by the parameter estimation unit 143, and may use an EKF algorithm to estimate an SOC of the battery 110 based on an error between the measured battery voltage $V_t$ and the estimated battery voltage $V\hat{}_t$. For example, the SOC estimation unit 144 may receive the present voltage value $V_t(k)$, the present current value $I_L(k)$, and the previous current value $I_L(k-1)$ from the receiver 141, receive the reference open-circuit voltage value $V_{OC,ref}(k)$ from the reference open-circuit voltage determination unit 142, and receive the first to third parameter values $\alpha_1(k)$, $\alpha_2(k)$, and $\alpha_3(k)$ from the parameter estimation unit 143. The SOC estimation unit 144 may determine the next SOC estimation value SOC(k+1) of the battery 110 by using an EKF, based on the SOC estimation value SOC(k), the present voltage value $V_t(k)$,

the reference open-circuit voltage value $V_{OC,ref}(k)$, the present current value $I_L(k)$, the previous current value $I_L(k-1)$, and the first to third parameter values $\alpha_1(k)$, $\alpha_2(k)$, and $\alpha_3(k)$. The SOC estimation unit 144 may use the SOC-$V_{OC,ref}$ relationship stored in the memory 150 to operate the EKF.

The EKF includes a state equation as shown in Equation 17 below and a battery model equation as shown in Equation 18 below.

[Equation 17]

$$SOC(k+1)=SOC(k)+ (\eta T/C_n)*I_L(k)+w(k)$$

Here, $\eta$ denotes the charge and discharge efficiency, $T$ denotes a sampling period, $C_n$ denotes the capacity of the battery, and $w(k)$ denotes process noise.

[Equation 18]

$$V_t(k)=\alpha_1(k)h(SOC(k))+\alpha_2(k)I_L(k)+\alpha_3(k)I_L(k-1)+v(k)$$

Here, $v(k)$ denotes observation noise, $h(SOC(k))$ denotes the reference open-circuit voltage value $V_{OC,ref}(k)$ corresponding to the SOC estimation value $SOC(k)$.

The first to third parameter values $\alpha_1(k)$, $\alpha_2(k)$, and $\alpha_3(k)$ of the battery parametric model estimated by the parameter estimation unit 143 are used by the SOC estimation unit 144 to estimate the SOC of the battery 110 by using an EKF algorithm. Equations for implementing the EKF algorithm are as follows.

$$SOC(k)=x_k, \ I_L(k)=u_k, \ V_t(k)=y_k$$

$$x_{k+1}=f(x_k, \ u_k)+w_k=x_k+(\eta T/C_n)u_k+w_k$$

$$y_k=g(x_k, \ u_k, \ u_{k-1})+v_k=\alpha_1 h(x_k)+\alpha_2 u_k+\alpha_3 u_{k-1}+v_k$$

$$A_k=1, \ B_k=\eta T/C_n, \ C_k=\alpha_{1,k}dh/dx|_{x=x_k}$$

$$P^-_k=A_{k-1}P^+_{k-1}A^T_{k-1}+Q$$

$$L_k=P^-_k(C_k)^T[C_kP^-_kC^T_k+R]^{-1}$$

$$x^{\wedge+}_k=x^{\wedge-}_k+L_k[y_k-g(x^{\wedge-}_k, \ u_k, \ u_{k-1})]$$

$$P^+_k=(I-L_kC_k)P^-_k$$

The SOC value $SOC(k)$ of the battery to be estimated in real time by the SOC estimation unit 144 is defined as a state $x_k$, and the voltage value $V_t(k)$ and the current value $I_L(k)$ measured by the voltage measurement unit 120 and the current measurement unit 130, respectively, are defined as variables $y_k$ and $u_k$ suitable for the EKF algorithm, respectively. In addition, a state equation (e.g., Equation 17) for the state $x_k$ and a battery model equation (e.g., Equation 18) for the battery voltage model are defined.

The SOC estimation unit 144 estimates an SOC suitable for the current state of the battery 110 by identifying the difference between a battery voltage estimation value $x^{\wedge-}_k$ estimated by using the first to third parameter values $\alpha_1(k)$, $\alpha_2(k)$, and $\alpha_3(k)$ of the battery parametric model estimated by the parameter estimation unit 143, and a currently measured battery voltage value $y_k$, selecting the state $x_k$ that minimizes the difference, and updating the state $x_k$ by a coulomb counting method.

Here, $x_k$ is defined as a state matrix, $y_k$ is defined as a measurement matrix, $u_k$ is defined as a control vector, $w_k$ is defined as process noise, $v_k$ is defined as observation noise, and $Q$ and $R$ are defined as the covariances of $w_k$ and $v_k$,

respectively. Q and R are user parameters and may be determined according to experimental data and environment. In general, the ratio of Q to R is important, and the degree of reflection of the state determined by a state equation for $x_{k+1}$ and a battery model equation for $y_k$ may be determined according to the ratio of Q to R.

The function h represents a reference SOC-$V_{OC,ref}$ curve at a representative reference temperature. That is, $h(x_k)$ outputs the reference open-circuit voltage value $V_{OC,ref}(k)$ for the state $x_k$.

In the above equations, + and - expressed in the exponents mean estimation times. For example, $x^{\wedge-}_k$ denotes $x^{\wedge}_k$ estimated at the (k-1)-th sampling time and $x^{\wedge+}_k$ denotes $x^{\wedge}_k$ estimated at the k-th sampling time.

The next SOC estimation value SOC(k+1) of the battery 110 estimated in real time by the SOC estimation unit 144 is used by the reference open-circuit voltage determination unit 142 to determine the reference open-circuit voltage value $V_{OC,ref}(k)$ at the next sampling time. The reference open-circuit voltage value $V_{OC,ref}(k)$ initially determined to be equal to the present voltage value $V_t(k)$ is updated to be the reference open-circuit voltage value $V_{OC,ref}(k)$ determined by the next SOC estimation value SOC(k+1). This process is repeated until the process of estimating the SOC of the battery 110 in real time is terminated.

Hereinafter, the result of verifying that the method of estimating an SOC of a battery according to the disclosure has higher accuracy than the related art will be described.

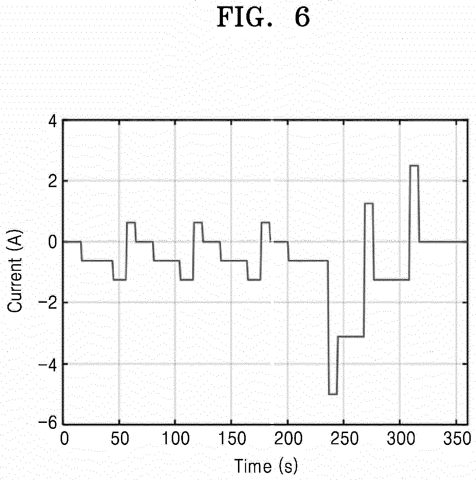

FIG. 6 shows a current waveform input to a battery to verify the accuracy of the method of estimating an SOC of a battery according to the disclosure.

In experimental verification, the current waveform shown in FIG. 6 is applied to a lithium-ion battery at -6 °C, and the voltage of the battery is measured. The current waveform shown in FIG. 6 is periodically applied to the battery. The current variation frequency of the current waveform may be higher than a preset rate such that first to third parameters may be sufficiently accurately estimated by the parameter estimation unit 143, and the measurement sampling rate may be sufficiently high compared to the current variation. In addition, the current waveform may satisfy a persistent excitation condition, and the current waveform shown in FIG. 6 satisfies the persistent excitation condition.

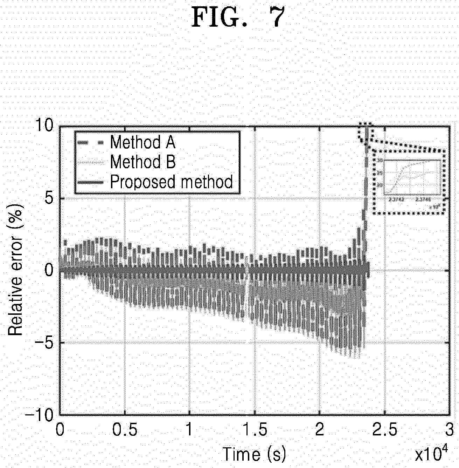

FIG. 7 shows relative errors between battery voltages estimated according to the related art and actually measured voltages (Method A and Method B), and relative errors between battery voltages estimated according to the disclosure and actually measured voltages (Proposed method), for which the current value of the current waveform of FIG. 6 applied to the battery and the voltage value of the battery measured accordingly were used.

For the related art, an SOC-Voc curve obtained by conducting a preliminary experiment at a corresponding experimental temperature was commonly used. Method A of the related art reflects battery characteristics in a lookup table at a preliminary experimental temperature, and Method B of the related art reflects battery characteristics at a preliminary experimental temperature in real-time estimation.

It may be seen that, the use of the methods of the related art in an extreme sub-zero temperature situation that greatly changes the characteristics of a battery results in battery voltage estimation errors fluctuating greatly up and down and thus large errors, whereas the use of the method according to the disclosure enables significantly improved and stable battery voltage estimation compared to the results of the related art.

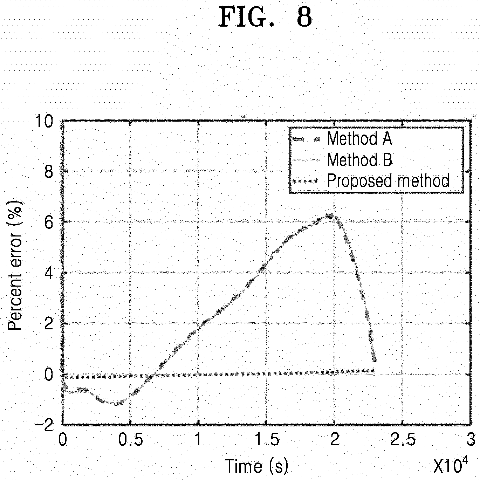

The method using the battery parametric model according to the disclosure has higher accuracy in estimating the SOC of a battery than the methods of the related art using the battery Thevenin model. As an example of experimental verification related to this, relative errors between SOCs of a battery estimated by using the related art (Method A and Method B) and the method according to the disclosure (Proposed method), by measuring the battery voltage while continuously discharging the battery at -8 °C with the current waveform shown in FIG. 6, and actual SOCs are shown in FIG. 8.

Although the EKF algorithm was used to estimate the SOC in the methods of the related art and the disclosure, referring to FIG. 8, it may be seen that the SOC estimation accuracy varies due to the difference in battery voltage modeling. While the SOC estimation error occurred up to about 6 % when using the methods of the related art, the maximum error was only about 0.2 % when using the method according to the disclosure. Therefore, it may be seen that the method according to the disclosure has a great effect in estimating an SOC.

Although the above experimental verification was conducted at one fixed temperature, it was additionally confirmed that the method according to the disclosure enables accurate battery voltage estimation and high SOC estimation accuracy even in a variable temperature situation in which the temperature changes in real time.

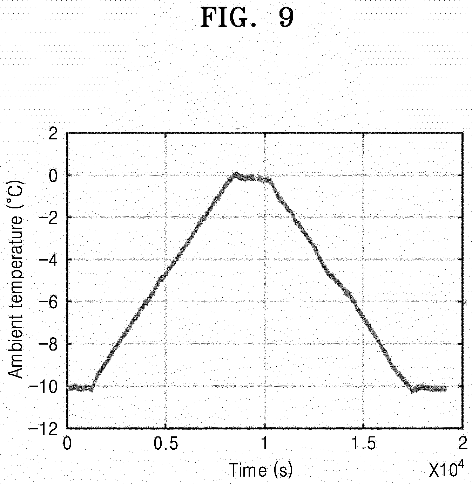

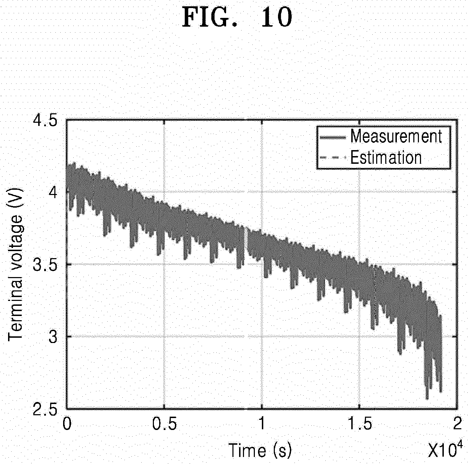

In this regard, FIG. 9 shows a real-time variable ambient temperature situation that is expected to occur in battery operation in winter. FIG. 10 shows the voltage (Measurement) measured when a battery is discharged in the variable temperature situation shown in FIG. 9, and the battery voltage (Estimation) estimated by using the method according to the disclosure. That is, the measured voltage value and the estimated voltage value were significantly similar to each other not only in a fixed temperature situation but also in the real-time variable temperature situation. Therefore, it may be seen that the effect of battery voltage estimation according to the disclosure is excellent.

In conclusion, battery voltage modeling and SOC estimation methods considering the temperature in the related art have a limitation that it is necessary to conduct various experiments to identify changes in battery characteristics at a plurality of temperature points including a battery operating temperature range, and even when the corresponding experimental data is used, a large voltage modeling error occurs due to the inaccuracy of an existing electrical model. On the contrary, the use of the estimation method according to the disclosure may remove the burden of preliminary temperature experiments, and it may be seen that the battery voltage estimation accuracy and SOC estimation accuracy are greatly improved.

According to the disclosure, it is possible to reduce the time and effort for a preliminary experiment by overcoming the limitation that the preliminary temperature experiment needs to be performed several times in order to analyze changes in battery characteristics according to the ambient temperature. In addition, in terms of accuracy, the voltage modeling accuracy and SOC estimation accuracy are greatly improved compared to electrical modeling methods commonly used in the related art. Accordingly, an accurate SOC may be obtained by a BMS regardless of the region in which the battery is used and temperature changes due to the season. In addition, through this, it is possible to accurately predict the remaining usage time of electric vehicles, portable electronic devices, etc. using batteries, and it can be of great help in improving battery management techniques such as capacity estimation or short circuit fault diagnosis.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims.

## Claims

1. A method of estimating a state of charge of a battery by using a battery parametric model, the method comprising:

   generating (S110) a present voltage value $Vt(k)$ and a present current value $I_L(k)$ by detecting a voltage and a current of the battery;
   determining (S120) a reference open-circuit voltage value $V_{OC,ref}(k)$ based on a state-of-charge estimation value $SOC(k)$;
   estimating (S130) first to third parameter values $\alpha_1(k)$, $\alpha_2(k)$, and $\alpha_3(k)$ from the present voltage value $Vt(k)$, the reference open-circuit voltage value $V_{OC,ref}(k)$, the present current value $I_L(k)$, and a previous current value $I_L(k-1)$ by using recursive least squares (RLS) and an equation for the battery parametric model; and
   determining (S140) a next state-of-charge estimation value $SOC(k+1)$ of the battery by using an extended Kalman filter (EKF), from the state-of-charge estimation value $SOC(k)$, the present voltage value $Vt(k)$, the reference open-circuit voltage value $Voc,ref(k)$, the present current value $I_L(k)$, the previous current value $I_L(k-1)$, and the first to third parameter values $\alpha_1(k)$, $\alpha_2(k)$, and $\alpha_3(k)$,
   wherein the equation for the battery parametric model is $V_t(k)=\alpha_1(k)V_{OC,ref}(k)+\alpha_2(k)I_L(k)+\alpha_3(k)I_L(k-1)$.

2. The method of claim 1, wherein the first to third parameter values $\alpha_1(k)$, $\alpha_2(k)$, and $\alpha_3(k)$ are estimated to minimize a square of an error $e(k)$ between the present voltage value $Vt(k)$ and a present voltage estimation value $V^\wedge_t(k)$.

3. The method of claim 1 or claim 2, wherein a parameter matrix $\theta(k)$ consisting of the first to third parameter values $\alpha_1(k)$, $\alpha_2(k)$, and $\alpha_3(k)$ is determined by the following equation:

$$\theta(k)=\theta(k-1)+K(k)e(k)$$

where $K(k)$ is a gain matrix, and the error $e(k)$ is determined according to $e(k)=V_t(k)-V^\wedge_t(k)$.

4. The method of claim 3, wherein the present voltage estimation value $V^\wedge_t(k)$ is determined by using a regressor matrix $\Phi(k)$ consisting of the reference open-circuit voltage value $Voc,ref(k)$, the present current value $I_L(k)$, and the previous current value $I_L(k-1)$, and a previous value $\theta(k-1)$ of the parameter matrix, according to $V^\wedge_t(k)=\theta^T(k-1)\Phi(k)$ where the regressor matrix $\Phi(k)$ is defined according to $\Phi(k)=[V_{OC,ref}(k), I_L(k), I_L(k-1)]^T$, and the parameter matrix $\theta(k)$ is defined according to $\theta(k)=[\alpha_1(k), \alpha_2(k), \alpha_3(k)]^T$.

5. The method of claim 3 or claim 4, wherein the gain matrix $K(k)$ is determined by the following equation:

$$K(k)=P(k)\Phi(k)=P(k-1)\Phi(k)/[\lambda(k)+\Phi^T(k)P(k-1)\Phi(k)]$$

where P(k) is a covariance matrix, and $\lambda(k)$ is a forgetting factor.

6. The method of claim 5, wherein the covariance matrix P(k) is determined by the following equation:

$$P(k)=(P(k-1)-K(k)\Phi^{\top}(k)P(k-1))/\lambda(k).$$

7. The method of claim 5 or claim 6, wherein a value of the forgetting factor $\lambda(k)$ decreases when a difference between the present voltage value Vt(k) and the previous voltage value $V_t(k-1)$ is greater than a preset value.

8. The method of any preceding claim, wherein the EKF comprises a state equation defined according to $SOC(k+1)=SOC(k)+ (\eta T/C_n)^*I_L(k)+w(k)$, and a battery model equation defined according to $V_t(k)=\alpha_1(k)h(SOC(k))+\alpha_2(k)I_L(k)+\alpha_3(k)I_L(k-1)+v(k)$, where $\eta$ is a charge and discharge efficiency, T is a sampling period, $C_n$ is capacity of the battery, w(k) is process noise, v(k) is observation noise, h(SOC(k)) is the reference open-circuit voltage value $V_{OC,ref}(k)$.

9. A computer program stored in a medium for causing a computing device to execute a method of estimating a state of charge of a battery by using a battery parametric model, the method comprising:

receiving (S110) a present voltage value Vt(k) and a present current value $I_L(k)$ which are generated by detecting a voltage and a current of the battery;
determining (S120) a reference open-circuit voltage value $V_{OC,ref}(k)$ based on a state-of-charge estimation value SOC(k);
estimating (S130) first to third parameter values $\alpha_1(k)$, $\alpha_2(k)$, and $\alpha_3(k)$ from the present voltage value Vt(k), the reference open-circuit voltage value $V_{OC,ref}(k)$, the present current value $I_L(k)$, and a previous current value $I_L(k-1)$ by using recursive least squares (RLS) and an equation for the battery parametric model; and
determining (S140) a next state-of-charge estimation value SOC(k+1) of the battery by using an extended Kalman filter (EKF), from the state-of-charge estimation value SOC(k), the present voltage value Vt(k), the reference open-circuit voltage value $Voc,_{ref}(k)$, the present current value $I_L(k)$, the previous current value $I_L(k-1)$, and the first to third parameter values $\alpha_1(k)$, $\alpha_2(k)$, and $\alpha_3(k)$ ,
wherein the equation for the battery parametric model is $V_t(k)=\alpha_1(k)V_{OC,ref}(k)+\alpha_2(k)I_L(k)+\alpha_3(k)I_L(k-1)$.

10. A device for estimating a state of charge of a battery by using a battery parametric model, the device comprising:

a memory (150) for storing an $SOC-V_{OC,ref}$ relationship between a state-of-charge value and an open-circuit voltage value of the battery at a reference temperature;
a receiver (141) configured to receive a present voltage value Vt(k) and a present current value $I_L(k)$, which are generated by detecting a voltage and a current of the battery;
a reference open-circuit voltage determination unit (142) configured to determine a reference open-circuit voltage value $V_{OC,ref}(k)$ corresponding to a state-of-charge estimation value SOC(k) by using the $SOC-V_{OC,ref}$ relationship stored in the memory;
a parameter estimation unit (143) configured to estimate first to third parameter values $\alpha_1(k)$, $\alpha_2(k)$, and $\alpha_3(k)$ by using recursive least squares (RLS) and an equation for the battery parametric model, from the present voltage value Vt(k), the reference open-circuit voltage value $Voc,_{ref}(k)$, the present current value $I_L(k)$, and a previous current value $I_L(k-1)$; and
a state-of-charge estimation unit (144) configured to determine a next state-of-charge estimation value SOC(k+1) of the battery by using an extended Kalman filter (EKF), from the state-of-charge estimation value SOC(k), the present voltage value Vt(k), the reference open-circuit voltage value $Voc,_{ref}(k)$, the present current value $I_L(k)$, the previous current value $I_L(k-1)$, and the first to third para1meter values $\alpha_1(k)$, $\alpha_2(k)$, and $\alpha_3(k)$ ,
wherein the equation for the battery parametric model is $V_t(k)=\alpha_1(k)V_{OC,ref}(k)+\alpha_2(k)I_L(k)+\alpha_3(k)I_L(k-1)$.

**Patentansprüche**

1. Verfahren zum Schätzen eines Ladezustands einer Batterie unter Verwendung eines parametrischen Batteriemodells, wobei das Verfahren Folgendes umfasst:

Erzeugen (S110) eines aktuellen Spannungswerts Vt(k) und eines aktuellen Stromwerts $I_L(k)$ durch Erfassen einer Spannung und eines Stroms der Batterie;

Bestimmen (S120) eines Referenz-Leerlaufspannungswerts $V_{OC,ref}(k)$ basierend auf einem Ladezustandsschätzwert SOC(k);

Schätzen (S130) erster bis dritter Parameterwerte $\alpha_1(k)$, $\alpha_2(k)$ und $\alpha_3(k)$ aus dem aktuellen Spannungswert Vt(k), dem Referenz-Leerlaufspannungswert $Voc_{,ref}(k)$, dem aktuellen Stromwert $I_L(k)$ und einem vorherigen Stromwert $I_L(k-1)$ unter Verwendung einer rekursiven Kleinstquadrate-Methode (RLS) und einer Gleichung für das parametrische Batteriemodell; und

Bestimmen (S140) eines nächsten Ladezustandsschätzwerts SOC(k+1) der Batterie unter Verwendung eines erweiterten Kalman-Filters (EKF) aus dem Ladezustandsschätzwert SOC(k), dem aktuellen Spannungswert Vt(k), dem Referenz-Leerlaufspannungswert $Voc_{,ref}(k)$, dem aktuellen Stromwert $I_L(k)$, dem vorherigen Stromwert $I_L(k-1)$ und den ersten bis dritten Parameterwerten $\alpha_1(k)$, $\alpha_2(k)$ und $\alpha_3(k)$,

wobei die Gleichung für das parametrische Batteriemodell $V_t(k)=\alpha_1(k)V_{OC,ref}(k)+\alpha_2(k)I_L(k)+\alpha_3(k)I_L(k-1)$ ist.

2. Verfahren nach Anspruch 1, wobei die ersten bis dritten Parameterwerte $\alpha_1(k)$, $\alpha_2(k)$ und $\alpha_3(k)$ geschätzt werden, um ein Quadrat eines Fehlers e(k) zwischen dem aktuellen Spannungswert Vt(k) und einem aktuellen Spannungs-schätzwert $V\hat{}_t(k)$ zu minimieren.

3. Verfahren nach Anspruch 1 oder Anspruch 2, wobei eine Parametermatrix θ(k), die aus den ersten bis dritten Parameterwerten $\alpha_1(k)$, $\alpha_2(k)$ und $\alpha_3(k)$ besteht, durch die folgende Gleichung bestimmt wird:

$$\theta(k)=\theta(k-1)+K(k)e(k)$$

wobei K(k) eine Verstärkungsmatrix ist und der Fehler e(k) gemäß $e(k)=V_t(k)-V\hat{}_t(k)$ bestimmt wird.

4. Verfahren nach Anspruch 3, wobei der aktuelle Spannungsschätzwert $V\hat{}_t(k)$ unter Verwendung einer Regressormatrix Φ(k), die aus dem Referenz-Leerlaufspannungswert $Voc_{,ref}(k)$, dem aktuellen Stromwert $I_L(k)$ und dem vorherigen Stromwert $I_L(k-1)$ sowie einem vorherigen Wert θ(k-1) der Parametermatrix besteht, gemäß $V\hat{}_t(k)=\theta^T(k-1)\Phi(k)$ bestimmt wird, wobei die Regressormatrix Φ(k) gemäß $\Phi(k)=[V_{OC,ref}(k), I_L(k), I_L(k-1)]^T$ definiert ist und die Parametermatrix θ(k) gemäß $\theta(k)=[\alpha_1(k), \alpha_2(k), \alpha_3(k)]^T$ definiert ist.

5. Verfahren nach Anspruch 3 oder Anspruch 4, wobei die Verstärkungsmatrix K(k) durch die folgende Gleichung bestimmt wird:

$$K(k)=P(k)\Phi(k)=P(k-1)\Phi(k)/[\lambda(k)+\Phi^T(k)P(k-1)\Phi(k)]$$

wobei P(k) eine Kovarianzmatrix und λ(k) ein Vernachlässigungsfaktor ist.

6. Verfahren nach Anspruch 5, wobei die Kovarianzmatrix P(k) durch die folgende Gleichung bestimmt wird:

$$P(k)=(P(k-1)-K(k)\Phi^T(k)P(k-1))/\lambda(k).$$

7. Verfahren nach Anspruch 5 oder Anspruch 6, wobei ein Wert des Vernachlässigungsfaktors λ(k) abnimmt, wenn eine Differenz zwischen dem aktuellen Spannungswert Vt(k) und dem vorherigen Spannungswert $V_t(k-1)$ größer als ein voreingestellter Wert ist.

8. Verfahren nach einem vorstehenden Anspruch, wobei das EKF eine Zustandsgleichung, die gemäß $SOC(k+1)=SOC(k)+(qT/C_n)*I_L(k)+w(k)$ definiert ist, und eine Batteriemodellgleichung, die gemäß $V_t(k)=\alpha_1(k)h(SOC(k))+\alpha_2(k)I_L(k)+\alpha_3(k)I_L(k-1)+v(k)$ definiert ist, umfasst, wobei η eine Lade- und Entladeeffizienz, T eine Abtastperiode, $C_n$ die Kapazität der Batterie, w(k) Prozessrauschen, v(k) Beobachtungsrauschen und h(SOC(k)) der Referenz-Leerlaufspannungswert $V_{OC,ref}(k)$ ist.

9. Computerprogramm, das auf einem Medium gespeichert ist, das eine Computervorrichtung veranlasst, ein Verfahren zum Schätzen eines Ladezustands einer Batterie unter Verwendung eines parametrischen Batteriemodells auszuführen, wobei das Verfahren Folgendes umfasst:

Empfangen (S110) eines aktuellen Spannungswerts Vt(k) und eines aktuellen Stromwerts $I_L(k)$, die durch Erfassen einer Spannung und eines Stroms der Batterie erzeugt werden;

Bestimmen (S120) eines Referenz-Leerlaufspannungswerts $V_{OC,ref}(k)$ basierend auf einem Ladezustandsschätzwert SOC(k);

Schätzen (S130) erster bis dritter Parameterwerte $\alpha_1(k)$, $\alpha_2(k)$ und $\alpha_3(k)$ aus dem aktuellen Spannungswert Vt(k), dem Referenz-Leerlaufspannungswert Voc,ref(k), dem aktuellen Stromwert $I_L(k)$ und einem vorherigen Stromwert $I_L(k-1)$ unter Verwendung einer rekursiven Kleinstquadrate-Methode (RLS) und einer Gleichung für das parametrische Batteriemodell; und

Bestimmen (S140) eines nächsten Ladezustandsschätzwerts SOC(k+1) der Batterie unter Verwendung eines erweiterten Kalman-Filters (EKF) aus dem Ladezustandsschätzwert SOC(k), dem aktuellen Spannungswert Vt(k), dem Referenz-Leerlaufspannungswert $V_{OC,ref}(k)$, dem aktuellen Stromwert $I_L(k)$, dem vorherigen Stromwert $I_L(k-1)$ und den ersten bis dritten Parameterwerten $\alpha_1(k)$, $\alpha_2(k)$ und $\alpha_3(k)$,

wobei die Gleichung für das parametrische Batteriemodell $V_t(k)=\alpha_1(k)V_{OC,ref}(k)+\alpha_2(k)I_L(k)+\alpha_3(k)I_L(k-1)$ ist.

10. Vorrichtung zum Schätzen eines Ladezustands einer Batterie unter Verwendung eines parametrischen Batteriemodells, wobei die Vorrichtung Folgendes umfasst:

einen Speicher (150) zum Speichern einer SOC-$V_{OC,ref}$-Beziehung zwischen einem Ladezustandswert und einem Leerlaufspannungswert der Batterie bei einer Referenztemperatur;

einen Empfänger (141), der dazu konfiguriert ist, einen aktuellen Spannungswert $V_t(k)$ und einen aktuellen Stromwert $I_L(k)$ zu empfangen, die durch Erfassen einer Spannung und eines Stroms der Batterie erzeugt werden;

eine Referenz-Leerlaufspannungsbestimmungseinheit (142), die dazu konfiguriert ist, einen Referenz-Leerlaufspannungswert Voc,ref(k), der einem Ladezustandsschätzwert SOC(k) entspricht, unter Verwendung der im Speicher gespeicherten SOC-$V_{OC,ref}$-Beziehung zu bestimmen;

eine Parameterschätzeinheit (143), die dazu konfiguriert ist, erste bis dritte Parameterwerte $\alpha_1(k)$, $\alpha_2(k)$ und $\alpha_3(k)$ unter Verwendung einer rekursiven Kleinstquadrate-Methode (RLS) und einer Gleichung für das parametrische Batteriemodell aus dem aktuellen Spannungswert Vt(k), dem Referenz-Leerlaufspannungswert Voc,ref(k), dem aktuellen Stromwert $I_L(k)$ und einem vorherigen Stromwert $I_L(k-1)$ zu schätzen; und

eine Ladezustandsschätzeinheit (144), die dazu konfiguriert ist, einen nächsten Ladezustandsschätzwert SOC(k+1) der Batterie unter Verwendung eines erweiterten Kalman-Filters (EKF) aus dem Ladezustandsschätzwert SOC(k), dem aktuellen Spannungswert Vt(k), dem Referenz-Leerlaufspannungswert Voc,ref(k), dem aktuellen Stromwert $I_L(k)$, dem vorherigen Stromwert $I_L(k-1)$ und den ersten bis dritten Parameterwerten $\alpha_1(k)$, $\alpha_2(k)$ und $\alpha_3(k)$ zu bestimmen,

wobei die Gleichung für das parametrische Batteriemodell $V_t(k)=\alpha_1(k)V_{OC,ref}(k)+\alpha_2(k)I_L(k)+\alpha_3(k)I_L(k-1)$ ist.

**Revendications**

1. Procédé d'estimation d'un état de charge d'une batterie en utilisant un modèle paramétrique de batterie, le procédé comprenant :

la génération (S110) d'une valeur de tension actuelle Vt(k) et d'une valeur de courant actuelle $I_L(k)$ en détectant une tension et un courant de la batterie ;

la détermination (S120) d'une valeur de tension de référence en circuit ouvert $V_{OC,ref}(k)$ sur la base d'une valeur d'estimation d'état de charge SOC(k) ;

l'estimation (S130) de première à troisième valeurs de paramètres $\alpha_1(k)$, $\alpha_2(k)$ et $\alpha_3(k)$ à partir de la valeur de tension actuelle Vt(k), de la valeur de tension de référence en circuit ouvert $V_{OC,ref}(k)$, de la valeur de courant actuelle $I_L(k)$ et d'une précédente valeur de courant $I_L(k-1)$ en utilisant les moindres carrés récursifs (RLS) et une équation pour le modèle paramétrique de batterie ; et

la détermination (S140) d'une prochaine valeur d'estimation d'état de charge SOC(k+1) de la batterie en utilisant un filtre de Kalman étendu (EKF), à partir de la valeur d'estimation d'état de charge SOC(k), de la valeur de tension actuelle Vt(k), de la valeur de tension de référence en circuit ouvert Voc,ref(k), de la valeur de courant actuelle $I_L(k)$, de la précédente valeur de courant $I_L(k-1)$, et des première à troisième valeurs de paramètres $\alpha_1(k)$, $\alpha_2(k)$ et $\alpha_3(k)$,

dans lequel l'équation du modèle paramétrique de batterie est $V_t(k)=\alpha_1(k)V_{OC,réf.}(k)+\alpha_2(k)I_L(k)+\alpha_3(k)I_L(k-1)$.

2. Procédé selon la revendication 1, dans lequel les première à troisième valeurs de paramètre $\alpha1(k)$, $\alpha_2(k)$ et $\alpha3(k)$ sont estimées pour réduire à un minimum un carré d'une erreur e(k) entre la valeur de tension actuelle Vt(k) et une valeur d'estimation de tension actuelle $V\hat{}_t(k)$.

3. Procédé selon la revendication 1 ou la revendication 2, dans lequel une matrice de paramètres $\theta(k)$ composée des première à troisième valeurs de paramètres $\alpha_1(k)$, $\alpha_2(k)$ et $\alpha_3(k)$ est déterminée par l'équation suivante :

$$\theta(k) = \theta(k - 1) + K(k)e(k)$$

dans laquelle $K(k)$ est une matrice de gain et l'erreur $e(k)$ est déterminée selon $e(k) = Vt(k) - V^\wedge_t(k)$.

4. Procédé selon la revendication 3, dans lequel la valeur d'estimation de tension actuelle $V^\wedge_t(k)$ est déterminée en utilisant une matrice de régression $\Phi(k)$ composée de la valeur de tension de référence en circuit ouvert $V_{OC,ref}(k)$, de la valeur de courant actuelle $I_L(k)$ et de la précédente valeur de courant $I_L(k-1)$, et d'une valeur précédente $\theta(k-1)$ de la matrice de paramètres, selon $V^\wedge_t(k) = \theta^T(k-1)\Phi(k)$ dans laquelle la matrice de régression $\Phi(k)$ est définie selon $\Phi(k) = [V_{OC,ref}(k), I_L(k), I_L(k-1)]^T$, et la matrice de paramètres $\theta(k)$ est définie selon $\theta(k) = [\alpha_1(k), \alpha_2(k), \alpha_3(k)]^T$.

5. Procédé selon la revendication 3 ou la revendication 4, dans lequel la matrice de gain $K(k)$ est déterminée par l'équation suivante :

$$K(k) = P(k)\Phi(k) = P(k - 1)\Phi(k)/[\lambda(k) + \Phi^T(k)P(k - 1)\Phi(k)]$$

dans laquelle $P(k)$ est une matrice de covariance et $\lambda(k)$ est un facteur d'oubli.

6. Procédé selon la revendication 5, dans lequel la matrice de covariance $P(k)$ est déterminée par l'équation suivante :

$$P(k) = (P(k - 1) - K(k)\Phi^T(k)P(k - 1))/\lambda(k).$$

7. Procédé selon la revendication 5 ou la revendication 6, dans lequel une valeur du facteur d'oubli $\lambda(k)$ diminue lorsqu'une différence entre la valeur de tension actuelle $Vt(k)$ et la précédente valeur de tension précédente $Vt(k-1)$ est supérieure à une valeur prédéfinie.

8. Procédé selon une quelconque revendication précédente, dans lequel l'EKF comprend une équation d'état définie selon $SOC(k + 1) = SOC(k) + (\eta T/C_n)^*I_L(k) + w(k)$, et une équation de modèle de batterie définie selon $Vt(k) = \alpha_1(k) h(SOC(k)) + \alpha_2(k)I_L(k) + \alpha_3(k)I_L(k - 1) + v(k)$, dans laquelle $\eta$ est une efficacité de charge et de décharge, $T$ est une période d'échantillonnage, $C_n$ est une capacité de la batterie, $w(k)$ est un bruit de processus, $v(k)$ est un bruit d'observation, $h(SOC(k))$ est la valeur de tension de référence en circuit ouvert $V_{OC,ref}(k)$.

9. Programme informatique enregistré sur un support pour amener un dispositif informatique à exécuter un procédé d'estimation d'un état de charge d'une batterie en utilisant un modèle paramétrique de batterie, le procédé comprenant :

la réception (S110) d'une valeur de tension actuelle $Vt(k)$ et d'une valeur de courant actuelle $I_L(k)$ qui sont générées en détectant une tension et un courant de la batterie ;
la détermination (S120) d'une valeur de tension de référence en circuit ouvert $V_{OC,ref}(k)$ sur la base d'une valeur d'estimation d'état de charge $SOC(k)$ ;
l'estimation (S130) de première à troisième valeurs de paramètres $\alpha_1(k)$, $\alpha_2(k)$ et $\alpha_3(k)$ à partir de la valeur de tension actuelle $Vt(k)$, de la valeur de tension de référence en circuit ouvert $V_{OC,ref}(k)$, de la valeur de courant actuelle $I_L(k)$ et d'une précédente valeur de courant $I_L(k-1)$ en utilisant les moindres carrés récursifs (RLS) et une équation pour le modèle paramétrique de batterie ; et
la détermination (S140) d'une prochaine valeur d'estimation d'état de charge $SOC(k+1)$ de la batterie en utilisant un filtre de Kalman étendu (EKF), à partir de la valeur d'estimation d'état de charge $SOC(k)$, de la valeur de tension actuelle $Vt(k)$, de la valeur de tension de référence en circuit ouvert $V_{OC,ref}(k)$, de la valeur de courant actuelle $I_L(k)$, de la précédente valeur de courant $I_L(k-1)$, et des première à troisième valeurs de paramètres $\alpha_1(k)$, $\alpha_2(k)$ et $\alpha_3(k)$,
dans lequel l'équation du modèle paramétrique de batterie est $Vt(k) = \alpha_1(k)V_{OC,ref}(k) + \alpha_2(k)I_L(k) + \alpha_3(k)I_L(k - 1)$.

10. Dispositif d'estimation d'un état de charge d'une batterie en utilisant un modèle paramétrique de batterie, le dispositif comprenant :

une mémoire (150) pour enregistrer une relation SOC-$V_{OC,ref}$ entre une valeur d'état de charge et une valeur de tension en circuit ouvert de la batterie à une température de référence ;

un récepteur (141) configuré pour recevoir une valeur de tension actuelle Vt(k) et une valeur de courant actuelle $I_L$(k), qui sont générées en détectant une tension et un courant de la batterie ;

une unité de détermination de tension de référence en circuit ouvert (142) configurée pour déterminer une valeur de tension de référence en circuit ouvert $V_{OC,ref}$ (k) correspondant à une valeur d'estimation d'état de charge SOC(k) en utilisant la relation SOC-$V_{OC,ref}$ enregistrée dans la mémoire ;

une unité d'estimation de paramètres (143) configurée pour estimer les première à troisième valeurs de paramètres $\alpha_1$(k), $\alpha_2$(k) et $\alpha_3$(k) en utilisant les moindres carrés récursifs (RLS) et une équation pour le modèle paramétrique de batterie, à partir de la valeur de tension actuelle Vt(k), de la valeur de tension de référence en circuit ouvert $V_{OC,ref}$ (k), de la valeur de courant actuelle $I_L$(k) et d'une précédente valeur de courant $I_L$ (k - 1) ; et

une unité d'estimation d'état de charge (144) configurée pour déterminer une prochaine valeur d'estimation d'état de charge SOC(k+1) de la batterie en utilisant un filtre de Kalman étendu (EKF), à partir de la valeur d'estimation d'état de charge SOC(k), de la valeur de tension actuelle Vt(k), de la valeur de tension de référence en circuit ouvert $V_{OC,ref}$ (k), de la valeur de courant actuelle $I_L$(k), de la précédente valeur de courant $I_L$(k-1), et des première à troisième valeurs de paramètres $\alpha_1$(k), $\alpha_2$(k) et $\alpha_3$(k),

dans lequel l'équation du modèle paramétrique de batterie est Vt(k) = $\alpha_1$(k)$V_{OC,réf.}$(k) + $\alpha_2$(k)$I_L$(k) + $\alpha_3$(k)$I_L$(k - 1).

# FIG. 1

# FIG. 2

```
              ( START )
                  │
                  ▼
┌─────────────────────────────┐
│   GENERATE PRESENT VOLTAGE  │
│  VALUE AND PRESENT CURRENT  │── S110
│       VALUE OF BATTERY      │
└─────────────────────────────┘
                  │
                  ▼
┌─────────────────────────────┐
│ DETERMINE REFERENCE OPEN-CIRCUIT │
│  VOLTAGE VALUE BASED ON STATE-   │── S120
│   OF-CHARGE ESTIMATION VALUE     │
└─────────────────────────────┘
                  │
                  ▼
┌─────────────────────────────┐
│     ESTIMATE FIRST TO THIRD │
│   PARAMETER VALUES BY USING │── S130
│    RECURSIVE LEAST SQUARES  │
└─────────────────────────────┘
                  │
                  ▼
┌─────────────────────────────┐
│    DETERMINE STATE-OF-CHARGE│
│     ESTIMATION VALUE BY USING    │
│ EXTENDED KALMAN FILTER BASED ON  │── S140
│  FIRST TO THIRD PARAMETER VALUES │
└─────────────────────────────┘
```

# FIG. 3

140

141

RECEIVER

142

REFERENCE
OPEN-CIRCUIT
VOLTAGE
DETERMINATION
UNIT

143

PARAMETER
ESTIMATION
UNIT

144

STATE-OF-CHARGE
ESTIMATION
UNIT

150

MEMORY

# FIG. 4

# FIG. 5

# FIG. 6

# FIG. 7

# FIG. 8

# FIG. 9

# FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20150377974 A1

**Non-patent literature cited in the description**

- **SHI NA et al.** Journal of Energy Storage. Elsevier, 17 November 2021, vol. 45